# EUROPEAN PATENT APPLICATION

(11) **EP 3 605 724 A1**
(43) Date of publication of application: **05.02.2020**
(21) Application number: 18771363.1
(22) Date of filing: 05.03.2018
(51) Int. Cl.: H01P 1/213, H01P 3/12, H01P 5/107

(54) **DIPLEXER**

(30) Priority: 24.03.2017 JP 2017059818
(71) Applicant: Fujikura Ltd., Tokyo 135-8512 (JP)
(72) Inventor: UEMICHI, Yusuke, Sakura-shi Chiba 285-8550 (JP)
(74) Representative: Plasseraud IP
(86) International application number: PCT/JP2018/008339
(87) International publication number: WO 2018/173721

(57) **Abstract**

An embodiment of the present invention provides greater isolation between a port serving as a Tx port and a port serving as an Rx port in a diplexer. A diplexer (1) includes: a filter pair (11) constituted by first and second filters (12, 13) having a passband which is a first frequency band, the first and second filters being arranged next to each other; first and second directional coupler sections (21, 31), each of which is connected to a respective one of opposite sides of the filter pair (11); and a third filter (41) which is connected to a port (third port 213) of the first directional coupler section (21) on a side away from the filter pair (11), the third filter having a passband which is a second frequency band.

## Description

### Technical Field

The present invention relates to a diplexer.

### Background Art

Devices that employ frequency division duplexing (FDD), such as radio communication equipment and radar devices, are required to transmit and receive high frequency signals (which are, for example, microwaves or millimeter waves) via a single antenna circuit shared by a transmitter circuit and a receiver circuit. To fulfill this requirement, a diplexer is used.

A diplexer is constituted by: converter sections which are interfaces for connection with a transmitter circuit, a receiver circuit, and an antenna circuit; directional coupler sections for coupling between a first waveguide and a second waveguide; and filters that determine a frequency band of high frequency signals to be passed.

For example, Non-Patent Literature 1 discloses techniques for realizing a diplexer, in Figure 18.35 thereof. Specifically, Non-Patent Literature 1 discloses combining (1) a filter pair constituted by two band-pass filters ("Rx filter" in Figure 18.35) arranged next to each other, (2) a directional coupler section ("90° hybrid" in Figure 18.35) provided on a first side of the filter pair, and (3) a directional coupler section ("90° hybrid" in Figure 18.35) provided on a second side of the filter pair.

In this diplexer, the directional coupler section on the first side includes an antenna port and a Tx port, and the directional coupler section on the second side includes an Rx port. The antenna port is for connecting an antenna which transmits outgoing waves and receives incoming waves. The Tx port is for connecting a transmitter circuit which transmits outgoing waves. The Rx port is for connecting a receiver circuit which receives incoming waves.

### Citation List

### [Non-patent Literature]

[Non-patent Literature 1]
Richard J. Cameron et al., MICROWAVE FILTERS for COMMUNICATION SYSTEMS, p.661-663, 2007 John Wiley & Sons, Inc.

### Summary of Invention

### Technical Problem

However, the conventional diplexer disclosed in Figure 18.35 of Non-Patent Literature 1 has the problem of insufficient isolation between the Tx port and Rx port. FDD involves transmitting outgoing waves simultaneously with reception of incoming waves. In devices that employ FDD, such as radio communication equipment and radar devices, insufficient isolation between the Tx port and the Rx port means that incoming waves will be buried by the outgoing waves. In other words, the receiver circuit will be unable to process the incoming waves. This is because the strength of incoming waves received by the antenna is much lower than the strength of outgoing waves transmitted by the transmitter circuit.

An object of an aspect of the present invention lies in achieving greater isolation between (i) a port which can be used as a Tx port and (ii) a port which can be used as an Rx port in a diplexer that includes ports which can be used as an antenna port, a Tx port, and an Rx port.

### Solution to Problem

In order to solve the above problem, a diplexer in accordance with an aspect of the present invention includes: a filter pair constituted by (i) a first filter including a first port and a second port and (ii) a second filter including a first port and a second port, the first filter and the second filter each having a passband that is a first frequency band, the first filter and the second filter being arranged next to each other; a first directional coupler section including a first port and a second port arranged next to each other and a third port and a fourth port arranged next to each other, the first port of the first directional coupler section being connected to the first port of the first filter, the second port of the first directional coupler section being connected to the first port of the second filter; a second directional coupler section including a first port and a second port arranged next to each other and a third port and a fourth port arranged next to each other, the first port of the second directional coupler section being connected to the second port of the first filter, the second port of the second directional coupler section being connected to the second port of the second filter; and a third filter having a passband that is a second frequency band differing from the first frequency band, the third filter including a first port and a second port, the first port of the third filter being connected to the third port of the first directional coupler section.

### Advantageous Effects of Invention

An aspect of the present invention makes it possible to achieve greater isolation between (i) a port which can be used as a Tx port and (ii) a port which can be used as an Rx port in a diplexer that includes ports which can be used as an antenna port, a Tx port, and an Rx port.

### Brief Description of Drawings

Fig. 1 is a block diagram illustrating a diplexer in accordance with Embodiment 1 of the present invention.
(a) Fig. 2 is a block diagram illustrating a first connection example in the diplexer of Fig. 1. (b) of Fig. 2 is a block diagram illustrating a second connection example in the diplexer of Fig. 1.
Fig. 3 is a perspective view illustrating a diplexer in accordance with Embodiment 2 of the present invention.
Fig. 4 is a plan view illustrating the diplexer in accordance with Embodiment 2 of the present invention.
(a) of Fig. 5 is a plan view of a converter section included in the diplexer in accordance with Embodiment 2 of the present invention. (b) of Fig. 5 is a cross-sectional view of the converter section illustrated in (a) of Fig. 5.
(a) of Fig. 6 is a plan view of a terminal section included in the diplexer in accordance with Embodiment 2 of the present invention. (b) of Fig. 6 is a cross-sectional view of the terminal section illustrated in (a) of Fig. 6.
(a), (b), and (c) of Fig. 7 are perspective views illustrating a directional coupler section, a filter pair, and a filter, respectively, of a diplexer in accordance with Embodiment 3 of the present invention.
(a) and (b) of Fig. 8 are each a graph illustrating an S parameter obtained in Example 1 of the present invention.
(a) and (b) of Fig. 9 are each a graph illustrating an S parameter obtained in Example 2 of the present invention.
(a) and (b) of Fig. 10 are each a graph illustrating an S parameter obtained in Comparative Examples 1 and 2, respectively, of the present invention.

### Description of Embodiments

### [Embodiment 1]

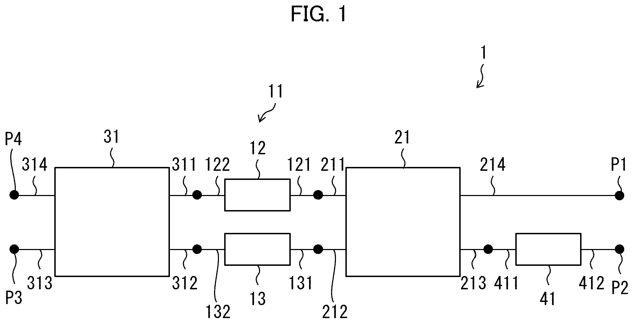

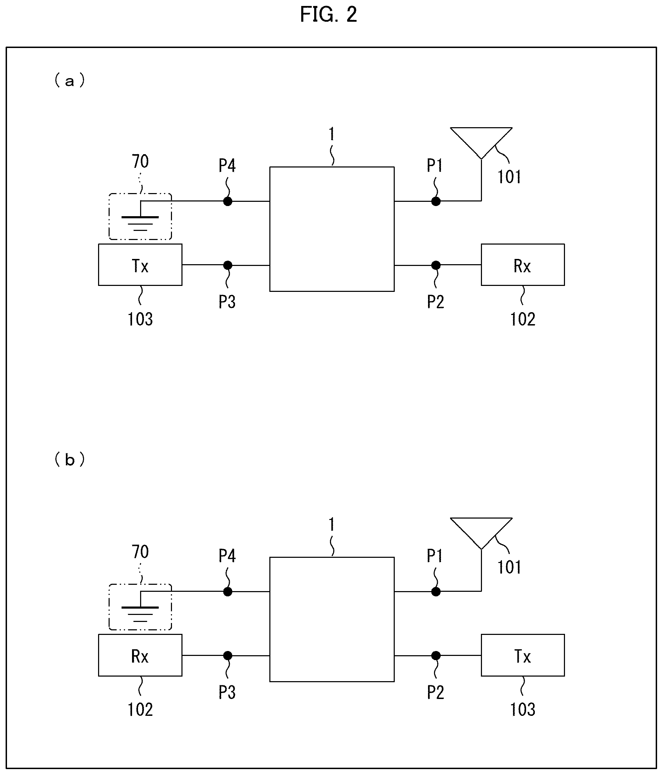

The following description will discuss a diplexer in accordance with Embodiment 1, with reference to Figs. 1 and 2. Fig. 1 is a block diagram illustrating a diplexer 1 in accordance with Embodiment 1. (a) Fig. 2 is a block diagram illustrating a first connection example in the diplexer 1. (b) of Fig. 2 is a block diagram illustrating a second connection example in the diplexer 1.

### (Configuration of diplexer 1)

As illustrated in Fig. 1, the diplexer 1 includes a filter pair 11, a directional coupler section 21, a directional coupler section 31, and a band-pass filter (BPF) 41. The directional coupler section 21 corresponds to the "first directional coupler section" recited in the claims, and the directional coupler section 31 corresponds to the "second directional coupler section" recited in the claims. The BPF 41 corresponds to the "third filter" recited in the claims.

The filter pair 11 includes a BPF 12 (corresponding to the "first filter" recited in the claims) and a BPF 13 (corresponding to the "second filter" recited in the claims) which are arranged next to each other. The BPF 12 includes a first port 121 and a second port 122. The BPF 13 includes a first port 131 and a second port 132. The BPF 41 includes a first port 411 and a second port 412. The BPF 12 and the BPF 13 have a passband which is a first frequency band. The BPF 41 has a passband which is a second frequency band that differs from the first frequency band. The radio wave passbands of the BPF 12, the BPF 13, and the BPF 41 will be described later.

The directional coupler section 21 includes a first port 211, a second port 212, a third port 213, and a fourth port 214. The first port 211 and the second port 212 are arranged next to each other. The third port 213 and the fourth port 214 are arranged next to each other. The first port 211 is connected to the first port 121 of the BPF 12. The second port 212 is connected to the first port 131 of the BPF 13. The third port 213 is connected to the first port 411 of the BPF 41.

The directional coupler section 31 includes a first port 311, a second port 312, a third port 313, and a fourth port 314. The first port 311 and the second port 312 are arranged next to each other. The third port 313 and the fourth port 314 are arranged next to each other. The first port 311 is connected to the second port 122 of the BPF 12. The second port 312 is connected to the second port 132 of the BPF 13.

In Embodiment 1, the port 214 of the directional coupler section 21 is referred to as a first port P1 of the diplexer 1, the port 412 of the BPF 41 is referred to as a second port P2 of the diplexer 1, the port 313 of the directional coupler section 31 is referred to as a third port P3 of the diplexer 1, and the port 314 of the directional coupler section 31 is referred to as a fourth port P4 of the diplexer 1.

### (Connection examples)

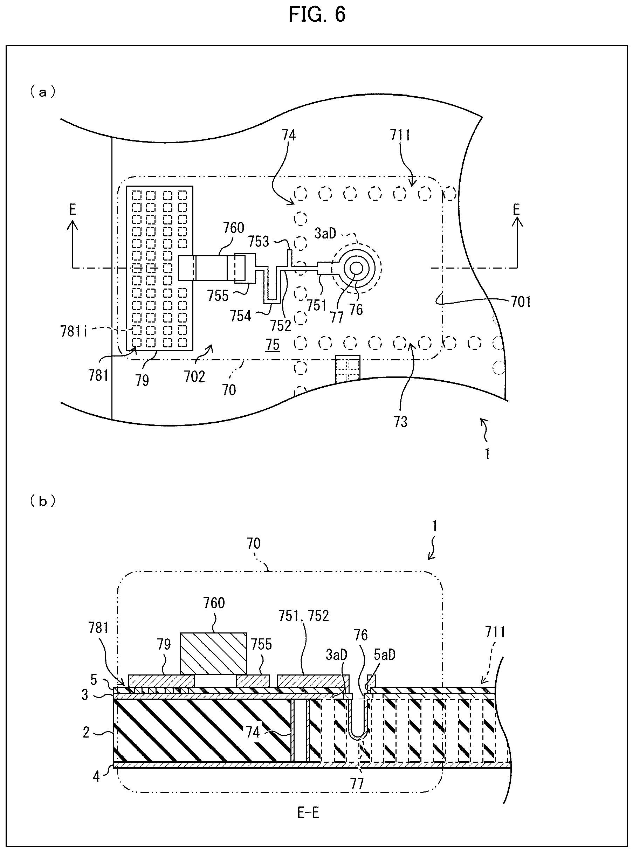

(a) of Fig. 2 illustrates a first connection example of the diplexer 1. As illustrated in (a) of Fig. 2, the diplexer 1 can be used in a state where an antenna 101 is connected to the first port P1, a receiver circuit (Rx) 102 is connected to the second port P2, and a transmitter circuit (Tx) 103 is connected to the third port P3. Note that the fourth port P4 is terminated with use of a terminal section 70. The terminal section 70 is described later with reference to Fig. 6.

In a case where the diplexer 1 is used in a state where the antenna 101, the Rx 102, and the Tx 103 are connected to the diplexer 1 as in the first connection example, the passband of the BPF 12 and BPF 13 which constitute the filter pair 11 encompasses a frequency band of outgoing waves transmitted from the Tx 103, and the passband of the BPF 41 encompasses the frequency band of incoming waves received by the Rx 102.

Hereinafter, out of a frequency band of not less than 70 GHz to less than 90 GHz (commonly known as an "E band"), a frequency band of not less than 70 GHz to less than 80 GHz is referred to as a "low band", and a frequency band of not less than 80 GHz to less than 90 GHz is referred to as a "high band".

Assume a case where the first frequency band, which is the frequency band of incoming waves received by the Rx 102, falls within the high band, and the second frequency band, which is the frequency band of outgoing waves transmitted by the Tx 103, falls within the low band. In such a case, the BPF 41 can be configured such that the passband of the BPF 41 is the first frequency falling within the high band, and the BPF 12 and BPF 13 can be configured such that the passband of the BPF 12 and BPF 13 is the second frequency band falling within the low band. One possible example of the first frequency band is an 81-86 GHz band (center frequency: 83.5 GHz), and one possible example of the second frequency band is a 71-76 GHz band (center frequency: 73.5 GHz).

Next, assume a case where, conversely, the first frequency band falls within the low band, and the second frequency band falls within the high band. In such a case, the BPF 41 can be configured such that the passband of the BPF 41 is the first frequency falling within the low band, and the BPF 12 and BPF 13 can be configured such that the passband of the BPF 12 and BPF 13 is the second frequency falling within the high band. One possible example of the first frequency band is a 71-76 GHz band (center frequency: 73.5 GHz), and one possible example of the second frequency band is an 81-86 GHz band (center frequency: 83.5 GHz).

Configuring the diplexer 1 to include the BPF 41 makes it possible to achieve greater isolation between the second port P2 and the third port P3 as compared to a conventional diplexer.

Note that even in a case where, as in the second connection example illustrated in (b) of Fig. 2, the transmitter circuit Tx is connected to the second port P2 and the receiver circuit Rx is connected to the third port P3, the diplexer 1 can still achieve greater isolation between the second port P2 and the third port P3 as compared to a conventional diplexer.

In a case where the diplexer 1 is used in a state where the antenna 101, the Rx 102, and the Tx 103 are connected to the diplexer 1 as in the second connection example, the BPF 12 and BPF 13 can be configured to have a passband which encompasses the incoming waves, and the BPF 41 can be configured to have a passband which encompasses the outgoing waves.

### [Embodiment 2]

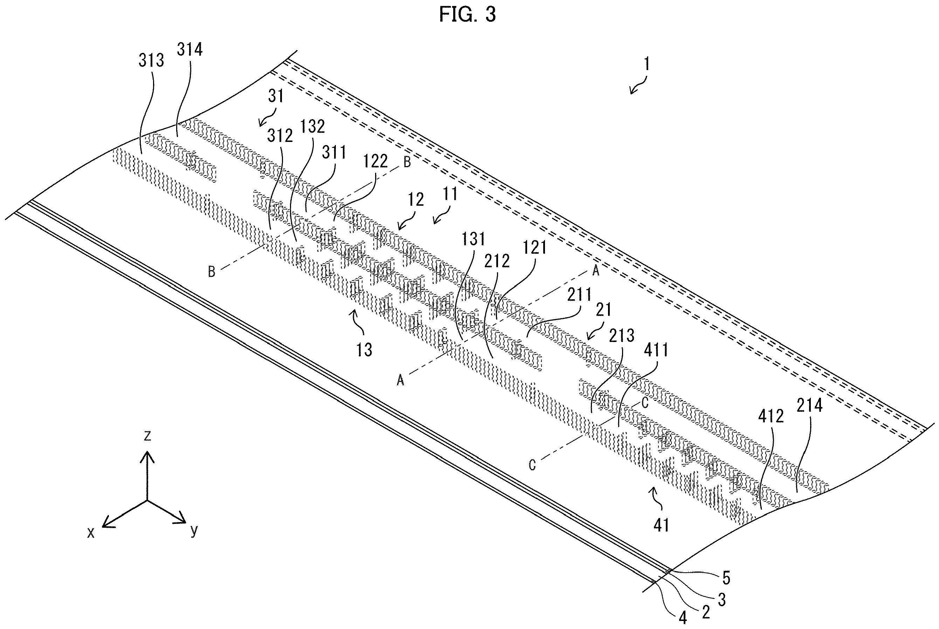

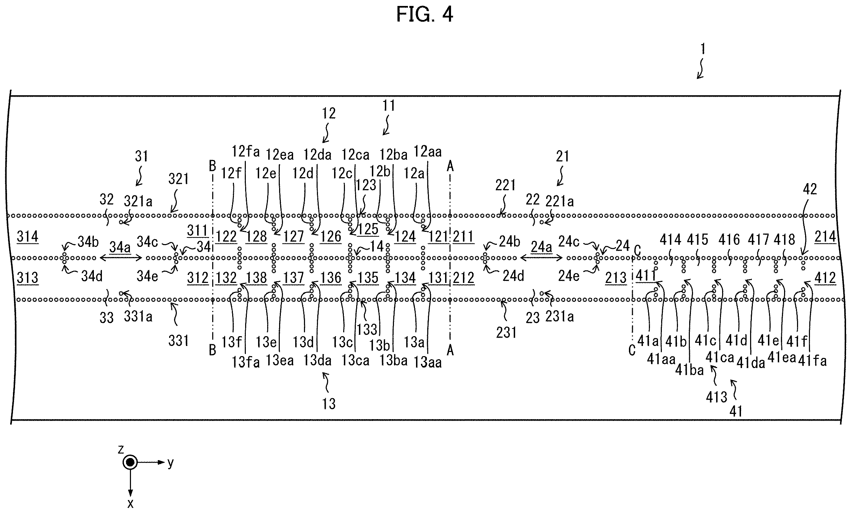

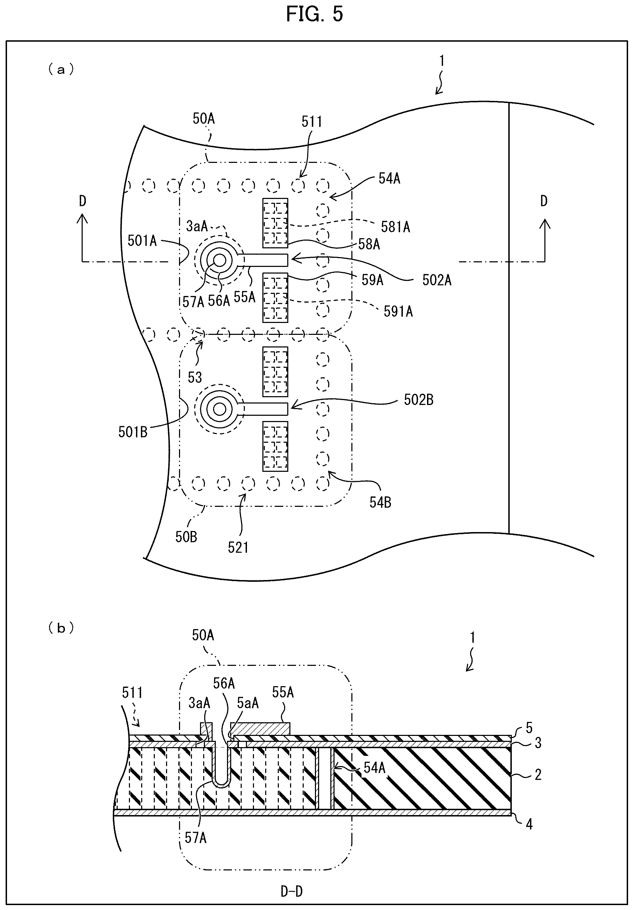

The following description will discuss a diplexer in accordance with Embodiment 2 of the present invention, with reference to Figs. 3 to 6. A diplexer 1 in accordance with Embodiment 2 is a first example configuration of the diplexer 1 in accordance with Embodiment 1. The diplexer 1 of Embodiment 2 utilizes a post-wall waveguide technique. In the following descriptions, "diplexer 1" refers to the diplexer 1 of Embodiment 2 unless stated otherwise. Fig. 3 is a perspective view of the diplexer 1. Fig. 4 is a plan view of the diplexer 1. (a) of Fig. 5 is a plan view of converter sections 50A and 50B of the diplexer 1. (b) of Fig. 5 is a cross-sectional view of the converter section 50A, taken along line DD in (a) of Fig. 5. (a) of Fig. 6 is a plan view of a terminal section 70 of the diplexer 1. (b) of Fig. 6 is a cross-sectional view of the terminal section 70, taken along line EE of (a) of Fig. 6.

### (Configuration of diplexer 1)

As illustrated in Fig. 3, the diplexer 1 includes: a substrate 2 which is a single dielectric substrate; a conductor layer 3; a conductor layer 4; and a dielectric layer 5.

The substrate 2 is a single substrate made of quartz, and is shared by the filter pair 11, the directional coupler section 21, the directional coupler section 31, and the BPF 41. The substrate 2 has six surfaces. In the following descriptions, out of these six surfaces, the two surfaces having the largest area are referred to as the main surfaces of the substrate 2. Note that the material for the substrate 2 is not limited to quartz, and may be a glass material other than quartz, a resin material such as polytetrafluoroethylene (for example, the material known as Teflon (registered trademark)) or a liquid crystal polymer, or a ceramic material.

The substrate 2 has regularly arranged through-holes each passing through the substrate 2 from front to back of the substrate 2. The through-holes each have a tube-shaped metal (e.g., copper) conductor film on the inner wall thereof. That is, the through-holes each have a metal conductor post formed inside thereof. In Embodiment 2, the diameter of each conductor post is 100 microns, and the distance between adjacent conductor posts (distance between the centers of adjacent conductor posts) is 200 microns.

Conductor posts regularly arranged in the above fence-like manner serve as post walls that reflect high frequency signals which are electromagnetic waves propagating through the substrate 2. In other words, the post walls serve as a kind of conductor wall. These conductor posts constitute narrow walls of the filter pair 11, the directional coupler sections 21 and 31, and the BPF 41. The layouts of the post walls for the filter pair 11, the directional coupler sections 21 and 31, and the BPF 41 will be described later with reference to another diagram.

The conductor layer 3 and the conductor layer 4 are a pair of conductor layers provided on opposite sides of the substrate 2. That is, the conductor layer 3 and the conductor layer 4 are each provided on a respective one of the two main surfaces of the substrate 2. The substrate 2, the conductor layer 3, and the conductor layer 4 have a laminated structure in which the substrate 2 is sandwiched between the conductor layers 3 and 4. In Embodiment 2, copper is used as a conductor constituting the conductor layers 3 and 4, but a different conductor (for example, a metal such as aluminum) may be used. The thickness of the conductor layers 3 and 4 is not limited to a particular thickness, and can be discretionarily chosen. In other words, the conductor layers 3 and 4 may be provided in the form of thin films, foil (films), or plates.

The respective waveguides of the filter pair 11, the directional coupler sections 21 and 31, and the BPF 41 each have the conductor layer 3 as a first wide wall and the conductor layer 4 as a second wide wall. The conductor layers 3 and 4 correspond to the "pair of conductor layers" recited in the claims.

As described above, four of the six faces of each of the filter pair 11 are constituted by the aforementioned narrow walls and the aforementioned pair of wide walls, four of the six faces of each of the directional coupler sections 21 and 31 are constituted by the aforementioned narrow walls and the aforementioned pair of wide walls, and four of the six faces of the BPF 41 are constituted by the aforementioned narrow walls and the aforementioned pair of wide walls.

The dielectric layer 5 is a conductor layer made of a polyimide resin and disposed on a surface of the conductor layer 3 (first wide wall). The material for the dielectric layer 5 may be a resin material other than polyimide resin.

With reference to Fig. 4, the following description will discuss details of the configurations of the filter pair 11, the directional coupler sections 21 and 31, and the BPF 41 of the diplexer 1.

### (Filter pair 11)

As described above with reference to Fig. 1, the filter pair 11 is made up of the BPF 12, which is the first filter, and the BPF 13, which is the second filter, the BPF 12 and the BPF 13 being arranged next to each other. The BPF 12 and the BPF 13 share a narrow wall 14. The BPF 12 includes a narrow wall 123 facing the narrow wall 14. Similarly, the BPF 13 includes a narrow wall 133 facing the narrow wall 14.

### (BPF 12)

The BPF 12 is a kind of waveguide (rectangular waveguide), four of whose faces are respectively constituted by the conductor layers 3 and 4 (which constitute a pair of wide walls) and the narrow walls 14 and 123 (which are a pair of narrow walls). The BPF 12 is designed to have a passband that is the first frequency band.

The BPF 12 is formed by six faces, two of which (opposite end faces of the BPF 12, i.e., the faces other than those constituted by the conductor layers 3 and 4 and the narrow walls 14 and 123) serve as a first port 121 and a second port 122, respectively, for electromagnetic connection between the BPF 12 and members outside the BPF 12. Hereinafter, the first port 121 and the second port 122 may also be referred to simply as a port 121 and a port 122, respectively.

As illustrated in Fig. 4, six partition walls 12a, 12b, 12c, 12d, 12e, and 12f are provided inside the BPF 12. Each of the partition walls 12a, 12b, 12c, 12d, 12e, and 12f is oriented so as to be disposed in a plane that intersects (perpendicularly, in Embodiment 2) with each of the conductor layers 3 and 4 and that intersects (perpendicularly, in Embodiment 2) with each of the narrow walls 14 and 123. In other words, each of the partition walls 12a, 12b, 12c, 12d, 12e, and 12f is formed in a zx plane, in terms of the coordinate system shown in Fig. 4.

The partition walls 12a, 12b, 12c, 12d, 12e, and 12f divide the BPF 12 into seven sections. These seven sections are (i) a section including the port 121, (ii) a section including the port 122, and (iii) five sections which are sandwiched between the section including the port 121 and the section including the port 122. The five sections which are sandwiched each have a rectangular parallelepiped shape whose top and bottom walls are formed by portions of the conductor layers 3 and 4, and whose side walls are formed by (i) a portion of the narrow walls 14 and 123 and (ii) two adjacent partition walls (for example, the partition walls 12a and 12b). As such, the five sections which are sandwiched each serve as a resonator. The five sections which are sandwiched are therefore referred to as resonators 124, 125, 126, 127, and 128, respectively.

The partition wall 12a has an opening 12aa. The opening 12aa serves as an inductive window through which (i) the section including the port 121 and (ii) the resonator 124 are electromagnetically coupled. The strength of coupling between the section including the port 121 and the resonator 124 is dependent on the width of the opening 12aa. A greater width of the opening 12aa correlates to a greater strength of this coupling.

Similarly to the opening 12aa, the partition wall 12b has an opening 12ba, the partition wall 12c has an opening 12ca, the partition wall 12d has an opening 12da, the partition wall 12e has an opening 12ea, and the partition wall 12f has an opening 12fa. The opening 12ba serves as an inductive window through which the resonator 124 and the resonator 125 are electromagnetically coupled. The opening 12ca serves as an inductive window through which the resonator 125 and the resonator 126 are electromagnetically coupled. The opening 12da serves as an inductive window through which the resonator 126 and the resonator 127 are electromagnetically coupled. The opening 12ea serves as an inductive window through which the resonator 127 and the resonator 128 are electromagnetically coupled. The opening 12fa serves as an inductive window through which the resonator 128 and the port 122 are electromagnetically coupled.

The resonator 124 and the resonator 128 correspond to the "first resonator" and the "second resonator" recited in the claims, respectively. In Embodiment 2, the resonator 124 and the resonator 128 are coupled via the resonators 125 to 127. Note, however, that the diplexer 1 need only include at least two resonators (the resonator 124 and the resonator 128). The resonator 124 and the resonator 128 may be coupled directly to each other, or may be coupled indirectly via one or more other resonators. In other words, the number of resonators included in the diplexer 1 need only be two or more.

The passband of the BPF 12 can be controlled by controlling parameters such as the number of resonators in the filter (this number being five in the diplexer 1), the size of each of the resonators, and/or the strength of coupling between adjacent resonators. Adjusting these parameters makes it possible to design a band-pass filter whose passband is the first frequency band (a desired frequency band).

Similarly to the narrow walls 14 and 123, each of the partition walls 12a, 12b, 12c, 12d, 12e, and 12f is constituted by conductor posts provided in a fence-like manner. Portions where these conductor posts are omitted serve as the openings 12aa, 12ba, 12ca, 12da, 12ea, and 12fa. The respective widths of the openings 12aa, 12ba, 12ca, 12da, 12ea, and 12fa can be controlled by the number of conductor posts omitted. Furthermore, the position of those conductor posts of the partition walls 12a, 12b, 12c, 12d, 12e, and 12f which define the opposite ends of each of the openings 12aa, 12ba, 12ca, 12da, 12ea, and 12fa can be finely adjusted in accordance with the respective widths (the widths determined at the time of design) of the openings 12aa, 12ba, 12ca, 12da, 12ea, and 12fa.

In Embodiment 2, the widths of the openings 12aa, 12ba, 12ca, 12da, 12ea, and 12fa become smaller with increasing distance from the port 121 and the port 122, i.e., become smaller with decreasing distance from the center of the BPF 12.

In the BPF 12 configured as described above, when a high frequency signal is externally supplied and coupled to the port 121 and propagates toward the port 122, the BPF 12 allows passage of a component of the high frequency signal which component has a frequency falling within a predetermined frequency band, and the BPF 12 reflects a component of the high frequency signal which component has a frequency not falling within the predetermined frequency band. That is, the BPF 12 serves as a band-pass filter (BPF) that allows passage of high frequency signals whose frequency falls within the predetermined frequency band.

### (BPF 13)

The BPF 13 is configured identically to the BPF 12. Therefore, the following description will only discuss the relationship between the BPF 13 and the BPF 12, and the details of the BPF 13 are omitted.

The BPF 13 is a kind of waveguide (rectangular waveguide), four of whose faces are respectively constituted by the conductor layers 3 and 4 (which constitute a pair of wide walls) and the narrow walls 14 and 133 (which are narrow walls).

The BPF 13 is formed by six faces, two of which (opposite end faces of the BPF 13, i.e., the faces other than those constituted by the conductor layers 3 and 4 and the narrow walls 14 and 133) serve as a first port 131 and a second port 132, respectively. Hereinafter, the first port 131 and the second port 132 may also be referred to simply as a port 131 and a port 132, respectively.

As illustrated in Fig. 4, the narrow wall 133 of the BPF 13 corresponds to the narrow wall 123 of the BPF 12, and the port 131, the port 132, and resonators 134 to 138 of the BPF 13 correspond to the port 121, the port 122, and the resonators 124 to 128 of the BPF 12, respectively. Partition walls 13a, 13b, 13c, 13d, 13e, and 13f, which are six partition walls provided within the BPF 13, correspond to the partition walls 12a, 12b, 12c, 12d, 12e, and 12f of the BPF 12, respectively. The partition walls 13a, 13b, 13c, 13d, 13e, and 13f have openings 13aa, 13ba, 13ca, 13da, 13ea, and 13fa, respectively, which correspond to the openings 12aa, 12ba, 12ca, 12da, 12ea, and 12fa of the BPF 12, respectively.

### (Directional coupler section 21)

As illustrated in Fig. 4, the directional coupler section 21 includes a waveguide 22, which is a first rectangular waveguide, and a waveguide 23, which is a second rectangular waveguide. The waveguide 22 and the waveguide 23 share a narrow wall 24 (first narrow wall) that has an opening 24a in the center of its length. The waveguides 22 and 23 have narrow walls 221 and 231 (second narrow walls), respectively, each of which faces the narrow wall 24. In other words, the waveguide 22 and the waveguide 23 are each a post-wall waveguide in which the narrow walls 221, 231, and 24 are constituted by conductor posts provided in a fence-like manner.

A pair of wide walls for the waveguide 22 is constituted by the conductor layers 3 and 4. The narrow wall 24 and the narrow wall 221 for the waveguide 22 are each constituted by conductor posts. Similarly, a pair of wide walls for the waveguide 23 is constituted by the conductor layers 3 and 4. The narrow wall 24 and the narrow wall 231, which are a pair of narrow walls, are each constituted by conductor posts.

The conductor posts constituting the narrow walls 221, 231, and 24 are configured similarly to the conductor posts constituting the filter pair 11.

The directional coupler section 21 includes a port 211 which is a first port, a port 212 which is a second port, a port 213 which is a third port, and a port 214 which is a fourth port. The port 21 1 is provided at a first end of the waveguide 22, and the port 214 is provided at a second end of the waveguide 22. The port 212 is provided at a first end of the waveguide 23, and the port 213 is provided at a second end of the waveguide 23. In other words, the port 211 and the port 212 are arranged next to each other, and the port 213 and the port 214 are arranged next to each other. The port 211 is connected to the port 121 of the BPF 12, and the port 212 is connected to the port 131 of the BPF 13.

Two conductor posts provided at opposite ends of the opening 24a are more widely spaced from each other than other conductor posts. The opening 24a serves as an inductive window through which the waveguide 22 and the waveguide 23 are coupled. The opening 24a formed in the narrow wall 24 causes, for example, a high frequency signal which is coupled to the first port 211 and which propagates from the first port 211 toward the fourth port 214 to be distributed from the waveguide 22 also to the waveguide 23 through the opening 24a. As a result, the high frequency signal coupled to the first port 211 reaches not only the fourth port 214 but also the third port 213.

By optimizing parameters such as the width of the opening 24a and the shapes of waveguides 22 and 23, it is possible to achieve a coupling factor of 3 dB between the waveguide 22 and the waveguide 23. The directional coupler section 21 is a 3 dB directional coupler section whose coupling factor is 3 dB. In a 3 dB directional coupler section, in a case where, for example, a high frequency signal is coupled to the first port 211, the electric field strength of the high frequency signal reaching the fourth port 214 and the electric field strength of the high frequency signal reaching the third port 213 are substantially equal to each other.

The waveguide 22 includes a projection 221a. The projection 221a protrudes toward the opening 24a from a part of a portion of the narrow wall 221 which portion is opposite the opening 24a. The projection 221a protrudes in a direction parallel to a positive x-axis direction. Similarly, the waveguide 23 includes a projection 231a. The projection 231a protrudes toward the opening 24a from a part of a portion of the narrow wall 231 which portion is opposite the opening 24a. The projection 231a protrudes in a direction parallel to a negative x-axis direction.

The waveguide 22 includes a projection 24b and a projection 24c which are formed in a symmetric manner with respect to the opening 24a. The projection 24b is provided at a position on the narrow wall 24 which position is more toward the port 211 than is the opening 24a. The projection 24c is provided at a position on the narrow wall 24 which position is more toward the port 214 than is the opening 24a. The projections 24b and 24c form a pair of projections, each of which protrudes from the narrow wall 24 and toward the narrow wall 221. The waveguide 23 includes a projection 24d and a projection 24e which are formed in a symmetric manner with respect to the opening 24a. The projection 24d is provided at a position on the narrow wall 24 which position is more toward the port 212 than is the opening 24a. The projection 24e is provided at a position on the narrow wall 24 which position is more toward the port 213 than is the opening 24a. The projections 24d and 24e form a pair of projections, each of which protrudes from the narrow wall 24 and toward the narrow wall 231.

By being configured to include the projections 221a and 231a, the pair of projections 24b and 24c, and the pair of projections 24d and 24e, the directional coupler section 21 is capable of reducing return loss in the operation band.

The configuration of the directional coupler section 21 is not limited to that illustrated in Fig. 4. Specifically, any directional coupler section can be used as the directional coupler section 21, provided that the directional coupler section is produced using a post-wall waveguide technique.

### (Directional coupler section 31)

The directional coupler section 31 is configured identically to the directional coupler section 21. Therefore, the following description will only discuss the relationship between the directional coupler section 31 and the directional coupler section 21, and the details of the directional coupler section 31 are omitted.

The directional coupler section 31 includes a waveguide 32, which is a first rectangular waveguide, and a waveguide 33, which is a second rectangular waveguide. The waveguides 32 and 33 of the directional coupler section 31 correspond to the waveguides 22 and 23 of the directional coupler section 21, respectively. That is, narrow walls 34, 321, and 331 of the directional coupler section 31 correspond to the narrow walls 24, 221, and 231 of the directional coupler section 21, respectively. An opening 34a in the narrow wall 34 corresponds to the opening 24a in the narrow wall 24. The directional coupler section 31 is a 3 dB directional coupler section, similarly to the directional coupler section 21.

The directional coupler section 31 includes a port 311 which is a first port, a port 312 which is a second port, a port 313 which is a third port, and a port 314 which is a fourth port. The ports 311, 312, 313, and 314 correspond to the ports 211, 212, 213, and 214 of the directional coupler section 21, respectively. The port 311 is connected to the port 122 of the BPF 12, and the port 312 is connected to the port 132 of the BPF 13.

The directional coupler section 31 has projections 321a and 331a which correspond to the projections 221a and 231a of the directional coupler section 21, respectively. The directional coupler section 31 also includes (i) a pair of projections 34b and 34c which correspond to the pair of projections 24b and 24c of the directional coupler section 21, respectively, and (ii) a pair of projections 34d and 34e which correspond to the pair of projections 24d and 24e of the directional coupler section 21, respectively.

### (BPF 41)

The BPF 41 is a band-pass filter whose passband is a second frequency band. The BPF 12 and the BPF 13 are designed to have a passband that is the first frequency band, whereas the BPF 41 is designed to have a passband that is the second frequency band. Except for the difference in passband, the BPF 41 is configured similarly to the BPF 12 and BPF 13. Therefore, the following description will only discuss the relationship between the BPF 41 and the BPF 13, and the details of the BPF 41 are omitted.

The BPF 41 is a kind of waveguide (rectangular waveguide), four of whose faces are respectively constituted by the conductor layers 3 and 4 (which constitute a pair of wide walls) and narrow walls 42 and 413 (which are narrow walls). The narrow wall 42 is provided continuously with the narrow wall 24 of the directional coupler section 21 and forms a part of a narrow wall of the waveguide 23 of the directional coupler section 21. In other words, the waveguide 23 and the BPF 41 share the narrow wall 42.

The BPF 41 is formed by six faces, two of which (opposite end faces of the BPF 41, i.e., the faces other than those constituted by the conductor layers 3 and 4 and the narrow walls 42 and 413) respectively serve as a port 411, which is a first port, and a port 412, which is a second port. The port 411 is coupled to the port 213 of the directional coupler section 21.

The narrow walls 42 and 413 of the BPF 41 correspond to the narrow walls 14 and 133 of the BPF 13, respectively. The first port 411, the second port 412, and resonators 414 to 418 of the BPF 41 correspond to the first port 131, the second port 132, and the resonators 134 to 138 of the BPF 13, respectively.

As illustrated in Fig. 4, six partition walls 41a, 41b, 41c, 41d, 41e, and 41f are provided inside the BPF 41. Thus, the BPF 41 is divided into seven compartments by the partition walls 41a, 41b, 41c, 41d, 41e, and 41f. The partition walls 41a, 41b, 41c, 41d, 41e, and 41f of the BPF 41 correspond to the partition walls 13a, 13b, 13c, 13d, 13e, and 13f of the BPF 13, respectively.

The partition walls 41a, 41b, 41c, 41d, 41e, and 41f have openings 41aa, 41ba, 41ca, 41da, 41ea, and 41fa, respectively.

The passband of the BPF 41 may be selected appropriately depending on the operation bands of a transmitter and a receiver connected to the diplexer 1. For example, in a case where, as illustrated in (a) of Fig. 2, the antenna 101 is connected to the first port P1, the Rx 102 is connected to the second port P2, and the Tx 103 is connected to the third port P3, the BPF 41 can be configured so as to allow passage of high frequency signals falling within the operation band of the Rx 102 and reflect high frequency signals falling within the operation band of the Tx 103.

### (Converter section)

The diplexer 1 further includes a converter section 50A coupled to the first port P1 (see Fig. 5), a converter section 50B coupled to the second port P2 (see Fig. 5), a converter section coupled to the third port P3, and a terminal section 70 coupled to the fourth port P4 (see Fig. 6). The converter section 50A and converter section 50B correspond to the "first converter section" and "second converter section" recited in the claims, respectively. The converter section coupled to the third port P3 corresponds to the "third converter section" recited in the claims. The terminal section 70 corresponds to the "fourth converter section" recited in the claims. The converter section 50B and the converter section coupled to the third port P3 are both configured identically to the converter section 50A. As such, the following description will discuss the converter section 50A and the terminal section 70.

### (Converter section 50A)

As illustrated in Fig. 5, the converter section 50A includes a port 501A, which is a first port, and a port 502A, which is a second port. The port 501A is coupled to the fourth port 214 of the directional coupler section 21.

The converter section 50A includes a waveguide (rectangular waveguide), five of whose faces are respectively constituted by the conductor layers 3 and 4 (which constitute a pair of wide walls), narrow walls 53 and 511 (which are a pair of narrow walls), and a short wall 54A. The short wall 54A is one of the post walls constituting the narrow walls of the converter section 50A, but is referred to as a short wall for distinction from the pair of narrow walls 53 and 511 opposite from each other. The short wall 54A is a narrow wall opposite from the port 501A. This waveguide is a post-wall waveguide. As with the narrow walls 53 and 511, the short wall 54A is a post wall constituted by conductor posts.

The waveguide of the converter section 50A is formed by six faces, one of which (one of the opposite end faces of the converter section 50A, i.e., the face other than those constituted by the conductor layers 3 and 4, narrow walls 511 and 53, and short wall 54A) serves as the port 501A for electromagnetic connection between the converter section 50A and members outside the converter section 50A.

As illustrated in (a) and (b) of Fig. 5, the converter section 50A includes the dielectric layer 5, a signal line 55A, a pad 56A, a blind via 57A, and electrodes 58A and 59A.

The dielectric layer 5 is provided on a surface of the conductor layer 3, which is the first wide wall. The dielectric layer 5 is provided so as to cover the surface of the conductor layer 3. The dielectric layer 5 is a single dielectric layer that is shared by the converter section 50A and converter section 50B (described later). The dielectric layer 5 has an opening 5aA that overlaps the waveguide of the converter section 50A.

The conductor layer 3, which is the first wide wall for the converter section 50A, has an opening 3aA that overlaps the opening 5aA. In Embodiment 2, the opening 3aA is formed such that the opening 3aA encompasses the opening 5aA within its range. The opening 3aA serves as an anti-pad. As has been described, the opening 5aA and the opening 3aA are each provided in a region that overlaps the waveguide of the converter section 50A.

The signal line 55A is a long, narrow conductor disposed on a surface of the dielectric layer 5. A first end portion of the signal line lies in a region that surrounds the opening 5aA and that overlaps the opening 3aA. The signal line 55A and the conductor layer 3 form a microstrip line.

The pad 56A is a circular conductor layer provided on the surface of the substrate 2 on which surface the conductor layer 3 is provided. The pad 56A is located inside the opening 3aA in the conductor layer 3 and insulated from the conductor layer 3.

The substrate 2 has a non-through-hole extending inward from the surface on which the conductor layer 3 is provided. The blind via 57A is constituted by a tube-shaped conductor film disposed on the inner wall of the non-through-hole. The blind via 57A is connected to a first end portion of the signal line 55A via the pad 56A so that the blind via 57A and the signal line 55A are in electrical communication with each other. In other words, the blind via 57A is electrically connected to the first end portion of the signal line 55A and is formed within the substrate 2.

The electrodes 58A and 59A are disposed on the surface of the dielectric layer 5. The electrodes 58A and 59A are located near a second end portion of the signal line 55A such that the second end portion of the signal line 55A lies between the electrodes 58A and 59A.

The dielectric layer 5 has through-holes in a region that overlaps the electrode 58. The through-holes are filled with a conductor to serve as vias 581A. The vias 581A achieve short circuiting between the electrode 58A and conductor layer 3.

Vias 591A, which are configured similarly to the vias 581A, achieve short circuiting between the electrode 59A and the conductor layer 3.

The second end portion of the signal line 55A and the electrodes 58A and 59A, which are arranged as described above, form the port 502A of the converter section 50A. The converter section 50A is capable of converting the mode of a high frequency signal coupled to the port 501A (high frequency signal having propagated through the waveguide 22) into the mode of a high frequency signal that is to propagate through the signal line 55A and the conductor layer 3, which constitute the microstrip line.

As illustrated in (a) of Fig. 5, the port 502A is constituted by: the signal line 55A, which is a constituent of the microstrip line; and the electrodes 58A and 59A, which are grounded and between which the second end portion of the signal line 55A is located. Therefore, a transmitter circuit that transmits high frequency signals, a receiver circuit that receives high frequency signals, or an antenna circuit that transmits and/or receives high frequency signals can be easily connected to the port 502A. It is preferable that the distance between the second end portion of the signal line 55A and the electrode 58A and the distance between the second end portion of the signal line 55A and the electrode 59A are selected so that the electrodes match the shape of a terminal of the transmitter circuit, receiver circuit, or antenna circuit connected to the port 502A.

### (Converter section 50B)

The converter section 50B is configured in a similar manner to the foregoing converter section 50A. Therefore, the following description will only discuss the relationship between the converter section 50B and the converter section 50A, and the details of the converter section 50B are omitted.

As illustrated in (a) of Fig. 5, the converter section 50B includes a port 501B and a port 502B. The port 501B and the port 502B of the converter section 50B correspond to the port 501A and the port 502A of the converter section 50A, respectively. The port 501B is connected to the port 412 of the BPF 41.

The converter section 50B includes a waveguide (rectangular waveguide), five of whose faces are respectively constituted by the conductor layers 3 and 4 (which constitute a pair of wide walls), narrow walls 53 and 521 (which are a pair of narrow walls), and a short wall 54B. The short wall 54B is one of the post walls constituting the narrow walls of the converter section 50B, but is referred to as a short wall for distinction from the pair of narrow walls 53 and 521 opposite from each other. The short wall 54B is a narrow wall opposite from the port 501B. This waveguide is a post-wall waveguide. As with the narrow walls 53 and 521, the short wall 54B is a post wall constituted by conductor posts.

The converter section 50B includes constituents corresponding to the signal line 55A, the pad 56A, the blind via 57A, and the electrodes 58A and 59A of the converter section 50A. The port 502B is constituted by: a second end portion of a signal line corresponding to the signal line 55A of the converter section 50A; and two electrodes corresponding to the electrodes 58A and 59A of the converter section 50A.

A transmitter circuit, a receiver circuit, or an antenna circuit can be connected to the port 502B, as with the port 502A.

### (Terminal section 70)

The terminal section 70 is a terminated converter section. The terminal section 70 further includes a configuration that reduces reflection.

As illustrated in (a) of Fig. 6, the terminal section 70 includes a port 701 and a port 702. The ports 701 and 702 of the terminal section 70 correspond to the ports 501A and 502A of the converter section 50A, respectively.

The terminal section 70 includes a waveguide (rectangular waveguide), five of whose faces are respectively constituted by the conductor layers 3 and 4 (which constitute a pair of wide walls), narrow walls 711 and 73 (which are a pair of narrow walls), and a short wall 74.

The terminal section 70 includes a signal line 75, a pad 76, a blind via 77, and an electrode 79. The signal line 75, the pad 76, the blind via 77, and the electrode 79 correspond to the signal line 55A, the pad 56A, the blind via 57A, and the electrodes 58A and 59A of the converter section 50A, respectively. Because the pad 76 and the blind via 77 correspond to the pad 56A and the blind via 57A, respectively, and descriptions therefor are omitted here.

The dielectric layer 5 has an opening 5aD corresponding to the opening 5aA illustrated in Fig. 5. The conductor layer 3 has an opening 3aD corresponding to the opening 3aA illustrated in Fig. 5.

The signal line 75 includes: a wide portion 751 constituting a first end portion of the signal line 75; a narrow portion 752 constituting an intermediate portion of the signal line 75; and a conductor pad 755 constituting a second end portion of the signal line 75.

The wide portion 751 is constituted by: a circular head portion; and a neck portion whose width is smaller than the diameter of the head portion. The narrow portion 752 is a long, narrow conductor connected to the wide portion 751, and is smaller in width than the neck portion of the wide portion 751. The conductor pad 755 is a rectangular piece of conductor.

The electrode 79 is a rectangular piece of conductor that is larger in area than each of the electrodes 58A and 59A. The electrode 79 is configured in this manner in order to further reduce the resistance and parasitic inductance component that would occur between the electrode 79 and the conductor layer 3 and to further stabilize the potential (ground potential) of the electrode 79. The dielectric layer 5 has through-holes in a region overlapping the electrode 79. The through-holes are filled with a conductor to serve as vias 781i. The vias 781i constitute a via group 781, which achieves short circuiting between the electrode 79 and the conductor layer 3.

The terminal section 70 further includes a resistor 760 for electrical communication between the conductor pad 755 and the electrode 79. The opposite ends of the resistor 760 are connected to the conductor pad 755 and the electrode 79, respectively, with a connection member (e.g., solder). Thus, the terminal section 70 is a terminated converter section. A chip resistor may be suitably used as the resistor 760.

The narrow portion 752 has an open stub 753 and a meander portion 754, each of which is provided somewhere between the opposite ends of the narrow portion 752. The open stub 753 is a long narrow conductor. A first end portion of the open stub 753 is connected somewhere between the opposite ends of the narrow portion 752, and a second end portion of the open stub 753 is open. The meander portion 754 is a long, narrow conductor that is equal in width to the narrow portion 752, and is meandered so that the path length of the narrow portion 752 increases.

The terminal section 70 is configured such that, by adjusting the lengths of the open stub 753 and the meander portion, it is possible to control the input impedance (in a direction from the waveguide to the terminal section, i.e., in the direction from the port 701 toward the port 702) to a desired value. In other words, the terminal section 70 configured as above can further reduce reflection. Thus, the terminal section 70 is capable of restricting a high frequency signal, coupled from the fourth port 314 of the directional coupler section 31, from being reflected at the terminal section 70 and becoming a reflected signal returning to the inside of the diplexer 1.

### [Embodiment 3]

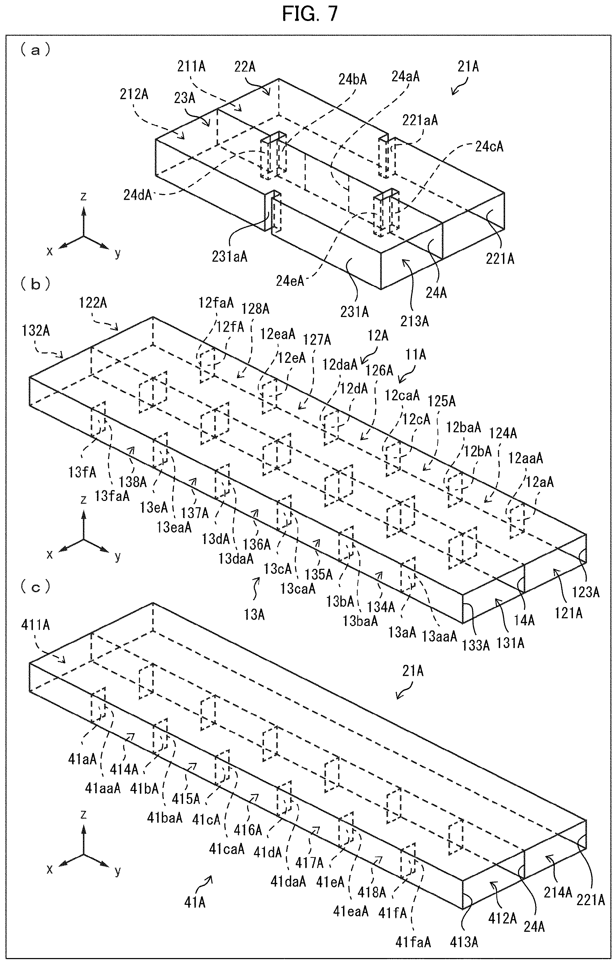

With reference to Fig. 7, the following description will discuss a diplexer in accordance with Embodiment 3 of the present invention. A diplexer 1A in accordance with Embodiment 3 is a second example configuration of the diplexer 1 in accordance with Embodiment 1. The diplexer 1A of Embodiment 3 utilizes metal waveguide tubes. The diplexer 1A includes a filter pair 11A, a directional coupler section 21A, a directional coupler section 31A, and a BPF 41A.

(a), (b), and (c) of Fig. 7 are perspective views illustrating the directional coupler section 21A, the filter pair 11A, and the BPF 41A of the diplexer 1A, respectively. The directional coupler section 31A is configured identically to the directional coupler section 21A, and is therefore not illustrated.

The diplexer 1 illustrated in Figs. 3 and 4 involved the use a post-wall waveguide technique to realize the diplexer 1 in accordance with Embodiment 1. However, a diplexer in accordance with an aspect of the present invention may be realized with use of a metal waveguide tube technique, as is done in the diplexer 1A illustrated in Fig. 7.

The various members of the diplexer 1A illustrated in Fig. 7 correspond to the various members of the diplexer 1 illustrated in Fig. 4. Corresponding members of the diplexer 1A and the diplexer 1 have reference symbols which are similar, with an additional "A" appended to the end of reference symbols for the diplexer 1A.

### [Example 1]

A diplexer 1 of Example 1 was prepared as an example of the diplexer 1 illustrated in Figs. 3 and 4.

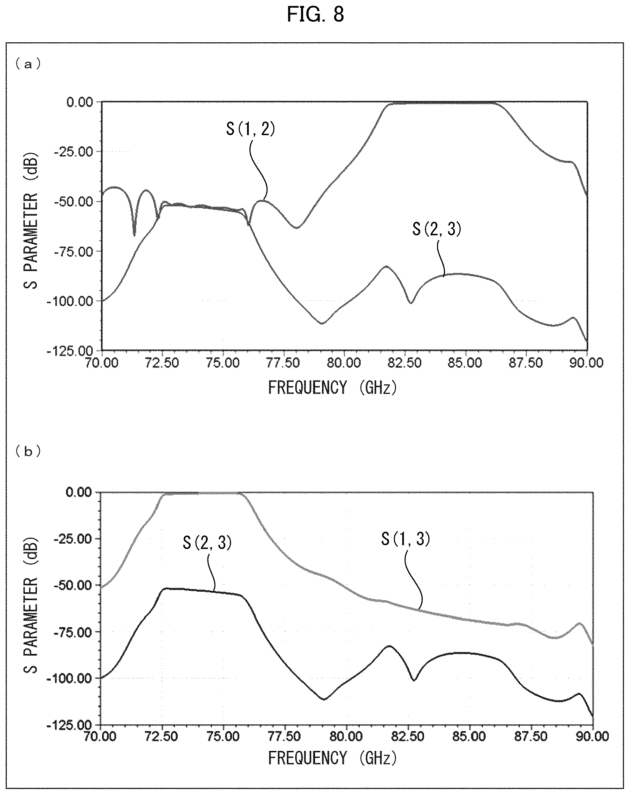

In the diplexer 1 of Example 1, the passband of the BPF 12 and BPF 13 is a 71-76 GHz band (center frequency: 73.5 GHz), and the passband of the BPF 41 is an 81-86 GHz band (center frequency: 83.5 GHz). (a) of Fig. 8 illustrates frequency dependence of an S parameter (derived via simulation) of the diplexer 1 of Example 1, as observed in a case where the Rx 102 is connected to the port P2 and the Tx 103 is connected to the port P3 as illustrated in (a) of Fig. 2. (b) of Fig. 8 illustrates frequency dependence of the S parameter (derived via simulation) of the diplexer 1 of Example 1, as observed in a case where the Tx 103 is connected to the port P2 and the Rx 102 is connected to the port P3 as illustrated in (b) of Fig. 2.

In the graph of (a) of Fig. 8, S(1, 2) indicates transmission characteristics from port P1 to port P2 (i.e., transmission characteristics from the antenna 101 to the Rx 102), and S(2, 3) indicates transmission characteristics from the port P2 to the port P3 (i.e., transmission characteristics from the Rx 102 to the Tx 103). In a case where the connection example illustrated in (a) of Fig. 2 is employed, the frequency band of incoming waves received by the Rx 102 is an 81-86 GHz band, and the frequency band of outgoing waves transmitted by the Tx 103 is a 71-76 GHz band.

In a case where the connection example illustrated in (a) of Fig. 2 is employed, in the 81-86 GHz band, it is desirable for the diplexer 1 to have properties such that S(1, 2) is large (good transmission characteristics) and S(2, 3) is small (good isolation characteristics).

(a) of Fig. 8 indicates that in the 81-86 GHz band, the value of S(2, 3) is -83 dB at the maximum value. It was thus found that the diplexer 1 of Example 1 had favorable isolation characteristics between the port P2 and the port P3.

In the graph of (b) of Fig. 8, S(1, 3) indicates transmission characteristics from port P1 to port P3 (i.e., transmission characteristics from the antenna 101 to the Rx 102), and S(2, 3) indicates transmission characteristics from the port P2 to the port P3 (i.e., transmission characteristics from the Rx 102 to the Tx 103). In a case where the connection example illustrated in (b) of Fig. 2 is employed, the frequency band of incoming waves received by the Rx 102 is a 71-76 GHz band, and the frequency band of outgoing waves transmitted by the Tx 103 is an 81-86 GHz band.

(b) of Fig. 8 indicates that in the 71-76 GHz band, the value of S(2, 3) is -52 dB at the maximum value. It was thus found that the diplexer 1 of Example 1 had favorable isolation characteristics between the port P2 and the port P3.

Thus, it was found that the diplexer 1 of Example 1 exhibits favorable isolation characteristics both when the connection example illustrated in (a) of Fig. 2 is employed and when the connection example illustrated in (b) of Fig. 2 is employed. Note that a comparison between the connection examples of (a) of Fig. 2 and (b) of Fig. 2 (i.e., a comparison between (a) and (b) of Fig. 8) shows that the connection example of (a) of Fig. 2 exhibits a more favorable isolation characteristic. In other words, the Rx 102 is more preferably connected to the port P2 than to the port P3, and the Tx 103 is more preferably connected to the port P3 than to the port P2.

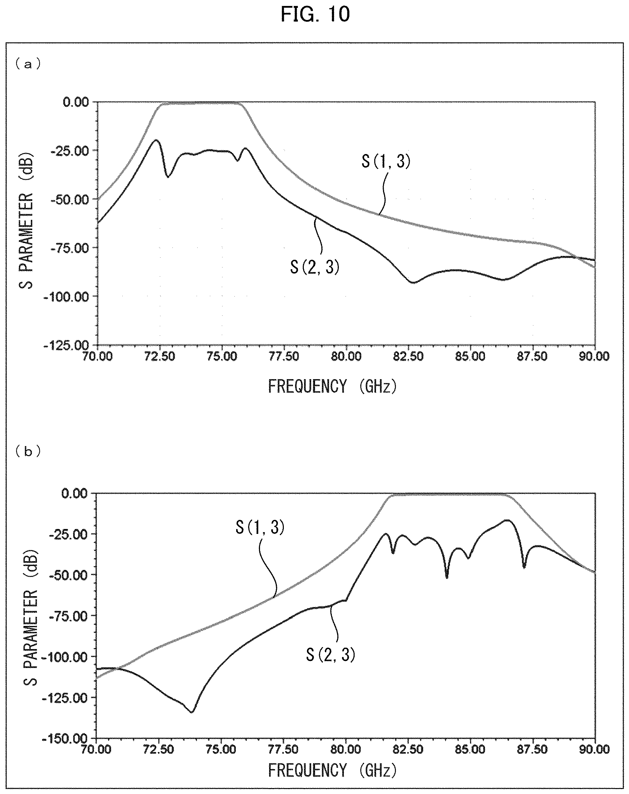

Used as a diplexer of Comparative Example 1 was a diplexer similar to the diplexer 1 of Example 1, except that the BPF 41 was omitted. (a) of Fig. 10 illustrates frequency dependence of the S parameter (derived via simulation) of the diplexer of Comparative Example 1, as observed in a case where the Tx 103 is connected to the port P2 and the Rx 102 is connected to the port P3 as illustrated in (b) of Fig. 2.

(a) of Fig. 10 indicates that in the 71-76 GHz band, the value of S(2, 3) is worsened to -20 dB at the maximum value. Thus, from a comparison of the graphs of (b) of Fig. 8 and (a) of Fig. 10, it can be seen that when employing the connection example of (b) of Fig. 2, inclusion of the BPF 41 in the diplexer 1 makes it possible to improve isolation characteristics between the port P2 and the port P3.

In a case where the connection example of (a) of Fig. 2 was employed in the diplexer of Comparative Example 1, it was similarly found that the value of S(2, 3) worsened to -20 dB at the maximum value. Thus, it was found that when employing the connection example of (a) of Fig. 2 as well, inclusion of the BPF 41 in the diplexer 1 improves isolation characteristics between the port P2 and the port P3.

### [Example 2]

A diplexer 1 of Example 2 was prepared as an example of the diplexer 1 illustrated in Figs. 3 and 4.

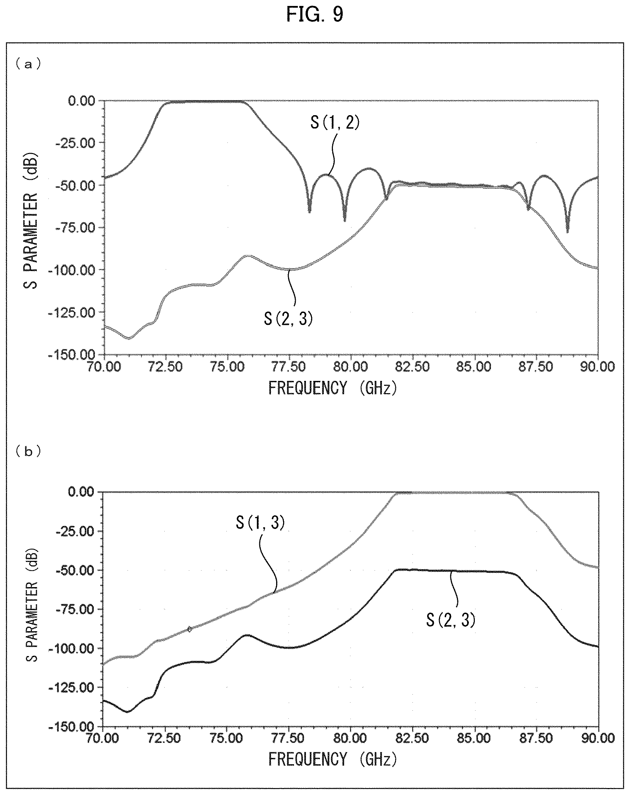

In the diplexer 1 of Example 2, the passband of the BPF 12 and BPF 13 is an 81-86 GHz band (center frequency: 83.5 GHz), and the passband of the BPF 41 is a 71-76 GHz band (center frequency: 73.5 GHz). (a) of Fig. 9 illustrates frequency dependence of an S parameter (derived via simulation) of the diplexer 1 of Example 2, as observed in a case where the Rx 102 is connected to the port P2 and the Tx 103 is connected to the port P3 as illustrated in (a) of Fig. 2. (b) of Fig. 9 illustrates frequency dependence of the S parameter (derived via simulation) of the diplexer 1 of Example 2, as observed in a case where the Tx 103 is connected to the port P2 and the Rx 102 is connected to the port P3 as illustrated in (b) of Fig. 2.

(a) of Fig. 9 indicates that in the 71-76 GHz band, the value of S(2, 3) is -92 dB at the maximum value. (b) of Fig. 9 indicates that in the 81-86 GHz band, the value of S(2, 3) is -51 dB at the maximum value. Thus, it was found that the diplexer 1 of Example 2 exhibits favorable isolation characteristics between the port P2 and the port P3 both when the connection example illustrated in (a) of Fig. 2 is employed and when the connection example illustrated in (b) of Fig. 2 is employed.

Note that a comparison between the connection examples of (a) of Fig. 2 and (b) of Fig. 2 (i.e., a comparison between (a) and (b) of Fig. 9) shows that the connection example of (a) of Fig. 2 exhibits a more favorable isolation characteristic. In other words, in Example 2 as well, the Rx 102 is more preferably connected to the port P2 than to the port P3, and the Tx 103 is more preferably connected to the port P3 than to the port P2.

Used as a diplexer of Comparative Example 2 was a diplexer similar to the diplexer of Example 2, except that the BPF 41 was omitted. (b) of Fig. 10 illustrates frequency dependence of the S parameter (derived via simulation) of the diplexer of Comparative Example 2, as observed in a case where the Tx 103 is connected to the port P2 and the Rx 102 is connected to the port P3 as illustrated in (b) of Fig. 2.

(b) of Fig. 10 indicates that in the 81-86 GHz band, the value of S(2, 3) is worsened to -15 dB at the maximum value. Thus, from a comparison of the graphs of (b) of Fig. 9 and (b) of Fig. 10, it can be seen that when employing the connection example of (b) of Fig. 2, inclusion of the BPF 41 in the diplexer 1 makes it possible to improve isolation characteristics between the port P2 and the port P3.

In a case where the connection example of (a) of Fig. 2 was employed in the diplexer of Comparative Example 2, it was similarly found that the value of S(2, 3) worsened to -15 dB at the maximum value. Thus, it was found that when employing the connection example of (a) of Fig. 2 as well, inclusion of the BPF 41 in the diplexer 1 improves isolation characteristics between the port P2 and the port P3.

Aspects of the present invention can also be expressed as follows.

A diplexer (1, 1A) in accordance with an aspect of the present invention includes: a filter pair (11, 11A) constituted by (i) a first filter (12, 12A) including a first port (121, 121A) and a second port (122, 122A) and (ii) a second filter (13, 13A) including a first port (131, 131A) and a second port (132, 132A), the first filter (12, 12A) and the second filter (13, 13A) each having a passband that is a first frequency band, the first filter (12, 12A) and the second filter (13, 13A) being arranged next to each other; a first directional coupler section (21, 21A) including a first port (211, 211A) and a second port (212, 212A) arranged next to each other and a third port (213, 213A) and a fourth port (214, 214A) arranged next to each other, the first port (211, 211A) of the first directional coupler section (21, 21A) being connected to the first port (121, 121A) of the first filter (12, 12A), the second port (212, 212A) of the first directional coupler section (21, 21A) being connected to the first port (131, 131A) of the second filter (13, 13A); a second directional coupler section (31, 31A) including a first port (311, 311A) and a second port (312, 312A) arranged next to each other and a third port (313, 313A) and a fourth port (314, 314A) arranged next to each other, the first port (311, 311A) of the second directional coupler section (31, 31A) being connected to the second port (122, 122A) of the first filter (12, 12A), the second port (312, 312A) of the second directional coupler section (31, 31A) being connected to the second port (132, 132A) of the second filter (13, 13A); and a third filter (41, 41A) having a passband that is a second frequency band differing from the first frequency band, the third filter (41, 41A) including a first port (411, 411A) and a second port (412, 412A), the first port (411, 411A) of the third filter (41, 41A) being connected to the third port (213, 213A) of the first directional coupler section (21, 21A).

The diplexer configured as above includes four ports, that is, (1) the fourth port of the first directional coupler section, (2) the second port of the third filter, (3) the third port of the second directional coupler section, and (4) the fourth port of the second directional coupler section. Out of these four ports, one port (for example, the fourth port of the first directional coupler section) can be used as an antenna port, another port (for example, the second port of the third filter) can be used as a Tx port or Rx port, and yet another port (for example, the third port of the second directional coupler section) can be used as the Rx port or the Tx port. In a case where the above "another port" is used as a Tx port, the above "yet another port" can be used as a Rx port; in a case where the above "another port" is used as an Rx port, the above "yet another port" can be used as a Tx port.

Because the diplexer includes the third filter, the diplexer is able to achieve greater isolation between (i) the second port of the third filter and (ii) the third and fourth ports of the second directional coupler section, as compared to a conventional diplexer. In other words, the diplexer makes it possible to achieve greater isolation between a port which can be used as a Tx port and a port which can be used as an Rx port.

In an aspect of the present invention, the diplexer (1, 1A) is preferably configured such that: the fourth port (214, 214A) of the first directional coupler section (21, 21A) is an antenna port for connection with an antenna (101); the second port (412, 412A) of the third filter (41, 41A) is an Rx port for connection with a receiver circuit (102); and the third port (313, 313A) of the second directional coupler section (31, 31A) is a Tx port for connection with a transmitter circuit (103).

In the diplexer configured as above, the fourth port of the first directional coupler section can be used as an antenna port, the second port of the third filter can be used as an Rx port, and the third port of the second directional coupler section can be used as a Tx port. Incoming waves inputted into the fourth port of the first directional coupler section (the antenna port) are outputted from the second port of the third filter (Rx port). Outgoing waves inputted into the diplexer via the third port of the second directional coupler section (Tx port) are outputted from the fourth port of the first directional coupler section (antenna port). The diplexer configured in this manner makes it possible to further improve isolation between the Rx port and the Tx port.

In an aspect of the present invention, the diplexer (1, 1A) is preferably configured such that: the first filter (12, 12A) includes a first resonator (124, 124A) and a second resonator (128, 128A) which are coupled to each other either directly or via one or more other resonators (125 to 127, 125A to 127A); the second filter (13, 13A) includes a first resonator (134, 134A) and a second resonator (138, 138A) which are coupled to each other either directly or via one or more other resonators (135 to 137, 135A to 137A); the third filter (41, 41A) includes a first resonator (414, 414A) and a second resonator (418, 418A) which are coupled to each other either directly or via one or more other resonators (415 to 417, 415A to 417A); the first directional coupler section (21, 21A) includes a first rectangular waveguide (22, 22A) and a second rectangular waveguide (23, 23A) which share a first narrow wall (24, 24A) having an opening (24a, 24aA), the first and second rectangular waveguides (22, 22A, 23, 23A) of the first directional coupler section (21, 21A) each having a respective second narrow wall (221, 231, 221A, 231A) facing the first narrow wall (24, 24A) of the first directional coupler section (21, 21A); the second directional coupler section (31, 31A) includes a first rectangular waveguide (32) and a second rectangular waveguide (33) which share a first narrow wall (34) having an opening (34a), the first and second rectangular waveguides (32, 33) of the second directional coupler section (31, 31A) each having a respective second narrow wall (321, 331) facing the first narrow wall (34) of the second directional coupler section (31, 31A); and respective waveguides of (i) the first and second filters of the filter pair (11, 11A), (ii) the third filter (41, 41A), (iii) the first directional coupler section (21, 21A), and (iv) the second directional coupler section (31, 31A) are post-wall waveguides that have a first wide wall (3), a second wide wall (4), and narrow walls, the first wide wall (3) and the second wide (4) wall being a pair of conductor layers (3, 4) provided on opposite sides of a single dielectric substrate (2), each of the narrow walls being a post wall constituted by conductor posts passing through the single dielectric substrate (2).

In the diplexer configured as described above, the filter pair, the first directional coupler section, the second directional coupler section, and the third filter are produced with use of a single dielectric substrate and a pair of conductor layers provided on the opposite sides of the dielectric substrate. That is, the diplexer is configured such that the filter pair, the first directional coupler section, the second directional coupler section, and the third filter are integrated into a single device with use of a post-wall waveguide technique.

As such, the diplexer is smaller and more lightweight than a diplexer constituted by metal waveguide tubes.

In an aspect of the present invention, the diplexer (1, 1A) is preferably configured to further include: a first converter section (50A) coupled to the fourth port (214, 214a) of the first directional coupler section (21, 21A); a second converter section (50B) coupled to the second port (412, 412A) of the third filter (41, 41A); a third converter section coupled to the third port (313, 313A) of the second directional coupler section (31, 31A); and a fourth converter section (70) coupled to the fourth port (314, 314A) of the second directional coupler section (31, 31A), wherein: each of the first to fourth converter sections (50A, 50B, 70) includes a respective waveguide which is a post-wall waveguide that has (i) a first wide wall (3) and a second wide wall (4) which are the pair of conductor layers (3, 4) and (ii) narrow walls which are each a post wall constituted by conductor posts passing through the single dielectric substrate (2); each of the first to fourth converter sections (50A, 50B, 70) has an opening (3aA, 3aD) in the first wide wall (3) of that converter section (50A, 50B, 70); and each of the first to fourth converter sections (50A, 50B, 70) further includes: a dielectric layer (5) disposed on a surface of the first wide wall (3) of that converter section (50A, 50B, 70), the dielectric layer (5) having an opening (5aA, 5aD) that overlaps the opening (3aA, 3aD) in the first wide wall (3) of that converter section (50A, 50B, 70); a signal line (55A, 75) disposed on a surface of the dielectric layer (5) of that converter section (50A, 50B, 70), a first end portion of the signal line (55A, 75) overlapping the opening (3aA, 3aD) in the first wide wall (3) and the opening (5aA, 5aD) in the dielectric layer (5) of that converter section (50A, 50B, 70); an electrode (58A, 59A, 79) disposed on the surface of the dielectric layer (5) of that converter section (50A, 50B, 70), the electrode (58A, 59A, 79) being in electrical communication with the first wide wall (3) of that converter section (50A, 50B, 70) via a via (581A, 591A, 781i) in the dielectric layer (5) of that converter section (50A, 50B, 70), and a blind via (57A, 77) provided in the dielectric substrate (5) of that converter section (50A, 50B, 70), the blind via (57A, 77) being in electrical communication with the first end portion of the signal line (55A, 75) of that converter section (50A, 50B, 70).

According to the above configuration, the respective signal lines of the first to fourth converter sections, together with the first wide wall, constitute respective microstrip lines. The microstrip line and the waveguide of each converter section are electromagnetically coupled together via the blind via. As such, each converter section is capable of converting the mode of a high frequency signal, which has propagated through the waveguide, into the mode of a high frequency signal that is to propagate through the microstrip line.

Furthermore, the dielectric layer of each converter section has, on its surface, the signal line and the electrode that is in electrical communication with the first wide wall. Therefore, the diplexer in accordance with an aspect of the present invention enables easier mounting of any of various circuits (e.g., transmitter circuit, receiver circuit, and antenna) to the converter sections, as compared to conventional diplexers.

In an embodiment of the present invention, the diplexer (1, 1A) is preferably configured such that the fourth converter section (70) further includes a resistor (760), via which electrical communication is achieved between (i) a second end portion of the signal line (75) of the fourth converter section (70) and (ii) the electrode (79) of the fourth converter section (70).

With the above configuration, use of the resistor makes it possible to easily achieve electrical communication between (i) the second end portion of the signal line of the fourth converter section and (ii) the electrode of the fourth converter section. That is, it is possible to easily terminate the fourth converter section. The terminated converter section reduces reflection to a greater extent than non-terminated converter sections (converter sections in which the second end portion of the signal line is open). As such, the terminated fourth converter section is capable of restricting a high frequency signal, inputted from one of the first to third converter sections, from being reflected at the fourth converter section and returning to the inside of the diplexer as a reflected signal.

In an embodiment of the present invention, the diplexer (1A) is preferably configured such that: the first filter (12A) includes a first resonator (124A) and a second resonator (128A) which are coupled to each other either directly or via one or more other resonators (125A to 127A); the second filter (13A) includes a first resonator (134A) and a second resonator (138A) which are coupled to each other either directly or via one or more other resonators (135A to 137A); the third filter (41A) includes a first resonator (414A) and a second resonator (418A) which are coupled to each other either directly or via one or more other resonators (415A to 417A); the first directional coupler section (21A) includes a first rectangular waveguide (22A) and a second rectangular waveguide (23A) which share a first narrow wall (24A) having an opening (24aA), the first and second rectangular waveguides (22A, 23A) of the first directional coupler section (21A) each having a respective second narrow wall (221A, 231A) facing the first narrow wall (24A) of the first directional coupler section (21A); the second directional coupler section (31A) includes a first rectangular waveguide (22A) and a second rectangular waveguide (23A) which share a first narrow wall (24A) having an opening (24aA), the first and second rectangular waveguides (22A, 23A) of the second directional coupler section (31A) each having a respective second narrow wall (221A, 231A) facing the first narrow wall (24A) of the second directional coupler section (31A); and respective waveguides of (i) the first and second filters of the filter pair (11A), (ii) the third filter (41A), (iii) the first directional coupler section (21A), and (iv) the second directional coupler section (31A) are constituted by metal waveguide tubes.

The above configuration can be suitably used in a case where metal waveguide tubes are used for (i) a port of an antenna to be connected with an antenna port, a port of a transmitter circuit to be connected with a Tx port, and a port of a receiver circuit to be connected with an Rx port. Using metal waveguide tubes for the antenna port, the Tx port, and the Rx port makes it possible to reduce return loss when the diplexer is connected to an antenna, a transmitter circuit, and a receiver circuit whose ports are constituted by metal waveguide tubes.

The present invention is not limited to the embodiments, but can be altered by a skilled person in the art within the scope of the claims. The present invention also encompasses, in its technical scope, any embodiment derived by combining technical means disclosed in differing embodiments.

### Reference Signs List

1 Diplexer
2 Substrate (dielectric substrate)
3 Conductor layer (constitutes a pair of conductor layers with the conductor layer 4)
4 Conductor layer (constitutes a pair of conductor layers with the conductor layer 3)
5 Dielectric layer
11, 11A Filter pair
12 BPF (first filter)
12a to 12f Partition wall
12aa to 12fa Opening
121 First port
122 Second port
123 Narrow wall
124 to 128 Resonator
13 BPF (second filter)
13a to 13f Partition wall
13aa to 13fa Opening
131 First port
132 Second port
133 Narrow wall
134 to 138 Resonator
14 Narrow wall
21, 21A Directional coupler section (first directional coupler section)
31 Directional coupler section (second directional coupler section)
211, 311 First port
212, 312 Second port
213, 313 Third port
214, 314 Fourth port
22, 22A, 32 Waveguide (first rectangular waveguide)
221, 321 Narrow wall (second narrow wall)
221a, 321a Projection
23, 23A, 33 Waveguide (second rectangular waveguide)
231, 331 Narrow wall (second narrow wall)
231a, 331a Projection
24, 24A, 34 Narrow wall (first narrow wall)
24a, 34a Opening
24b to 24e, 34b to 34e Projection
41, 41A BPF (third filter)
41a to 41f Partition wall
41aa to 41fa Opening
411 First port
412 Second port
413 Narrow wall
414 to 418 Resonator
50A Converter section
50B Converter section
55A Signal line
57A Blind via
58A, 59A, 79 Electrode
70 Terminal section (terminated converter section)
75 Signal line
77 Blind via
760 Resistor
101 Antenna
102 Rx (receiver circuit)
103 Tx (transmitter circuit)

## Claims

1. A diplexer comprising:
a filter pair constituted by (i) a first filter including a first port and a second port and (ii) a second filter including a first port and a second port, the first filter and the second filter each having a passband that is a first frequency band, the first filter and the second filter being arranged next to each other;
a first directional coupler section including a first port and a second port arranged next to each other and a third port and a fourth port arranged next to each other, the first port of the first directional coupler section being connected to the first port of the first filter, the second port of the first directional coupler section being connected to the first port of the second filter;
a second directional coupler section including a first port and a second port arranged next to each other and a third port and a fourth port arranged next to each other, the first port of the second directional coupler section being connected to the second port of the first filter, the second port of the second directional coupler section being connected to the second port of the second filter; and
a third filter having a passband that is a second frequency band differing from the first frequency band, the third filter including a first port and a second port, the first port of the third filter being connected to the third port of the first directional coupler section.

2. The diplexer according to claim 1, wherein:
the fourth port of the first directional coupler section is an antenna port for connection with an antenna;
the second port of the third filter is an Rx port for connection with a receiver circuit; and
the third port of the second directional coupler section is a Tx port for connection with a transmitter circuit.

3. The diplexer according to claim 1 or 2, wherein:
the first filter includes a first resonator and a second resonator which are coupled to each other either directly or via one or more other resonators;
the second filter includes a first resonator and a second resonator which are coupled to each other either directly or via one or more other resonators;
the third filter includes a first resonator and a second resonator which are coupled to each other either directly or via one or more other resonators;
the first directional coupler section includes a first rectangular waveguide and a second rectangular waveguide which share a first narrow wall having an opening, the first and second rectangular waveguides of the first directional coupler section each having a respective second narrow wall facing the first narrow wall of the first directional coupler section;
the second directional coupler section includes a first rectangular waveguide and a second rectangular waveguide which share a first narrow wall having an opening, the first and second rectangular waveguides of the second directional coupler section each having a respective second narrow wall facing the first narrow wall of the second directional coupler section; and
respective waveguides of (i) the first and second filters of the filter pair, (ii) the third filter, (iii) the first directional coupler section, and (iv) the second directional coupler section are post-wall waveguides that have a first wide wall, a second wide wall, and narrow walls, the first wide wall and the second wide wall being a pair of conductor layers provided on opposite sides of a single dielectric substrate, each of the narrow walls being a post wall constituted by conductor posts passing through the single dielectric substrate.

4. The diplexer according to claim 3, further comprising:
a first converter section coupled to the fourth port of the first directional coupler section;
a second converter section coupled to the second port of the third filter;
a third converter section coupled to the third port of the second directional coupler section; and
a fourth converter section coupled to the fourth port of the second directional coupler section,
wherein:
each of the first to fourth converter sections includes a respective waveguide which is a post-wall waveguide that has (i) a first wide wall and a second wide wall which are the pair of conductor layers and (ii) narrow walls which are each a post wall constituted by conductor posts passing through the single dielectric substrate;
each of the first to fourth converter sections has an opening in the first wide wall of that converter section; and
each of the first to fourth converter sections further includes:
a dielectric layer disposed on a surface of the first wide wall of that converter section, the dielectric layer having an opening that overlaps the opening in the first wide wall of that converter section;
a signal line disposed on a surface of the dielectric layer of that converter section, a first end portion of the signal line overlapping the opening in the first wide wall and the opening in the dielectric layer of that converter section;
an electrode disposed on the surface of the dielectric layer of that converter section, the electrode being in electrical communication with the first wide wall of that converter section via a via in the dielectric layer of that converter section, and
a blind via provided in the dielectric substrate of that converter section, the blind via being in electrical communication with the first end portion of the signal line of that converter section.

5. The diplexer according to claim 4, wherein the fourth converter section further includes a resistor, via which electrical communication is achieved between (i) a second end portion of the signal line of the fourth converter section and (ii) the electrode of the fourth converter section.

6. The diplexer according to claim 1 or 2, wherein:
the first filter includes a first resonator and a second resonator which are coupled to each other either directly or via one or more other resonators;
the second filter includes a first resonator and a second resonator which are coupled to each other either directly or via one or more other resonators;
the third filter includes a first resonator and a second resonator which are coupled to each other either directly or via one or more other resonators;
the first directional coupler section includes a first rectangular waveguide and a second rectangular waveguide which share a first narrow wall having an opening, the first and second rectangular waveguides of the first directional coupler section each having a respective second narrow wall facing the first narrow wall of the first directional coupler section;
the second directional coupler section includes a first rectangular waveguide and a second rectangular waveguide which share a first narrow wall having an opening, the first and second rectangular waveguides of the second directional coupler section each having a respective second narrow wall facing the first narrow wall of the second directional coupler section; and
respective waveguides of (i) the first and second filters of the filter pair, (ii) the third filter, (iii) the first directional coupler section, and (iv) the second directional coupler section are constituted by metal waveguide tubes.
